# EUROPEAN PATENT APPLICATION

(11) **EP 4 443 478 A1**
(43) Date of publication of application: **09.10.2024**
(21) Application number: 22900910.5
(22) Date of filing: 07.10.2022
(51) Int. Cl.: H01L 21/31, H01L 21/3065, H01L 21/316, H01L 21/318

(54) **METHOD FOR FORMING DEPOSITION FILM**

(30) Priority: 02.12.2021 JP 2021196385; 24.02.2022 JP 2022027236; 07.06.2022 JP 2022092299
(71) Applicant: Resonac Corporation, Tokyo 105-7325 (JP)
(72) Inventor: SATO Daisuke, Tokyo 105-8518 (JP); OKA Yuki, Tokyo 105-8518 (JP); TANIWAKI Moe, Tokyo 105-8518 (JP)
(74) Representative: Strehl Schübel-Hopf & Partner
(86) International application number: PCT/JP2022/037688
(87) International publication number: WO 2023/100476

(57) **Abstract**

Provided is a method for forming a deposition film, with which a deposition film having improved uniformity of a film thickness can be formed. The method for forming a deposition film is a method for forming a deposition film on a substrate (21) on which a pattern (22) is formed, and the method includes a deposition step of placing the substrate (21) on an electrode and applying bias power to the electrode to form a deposition film (40) on the substrate (21) using plasma obtained by plasma-processing a deposition gas. A material constituting the pattern (22) is at least one of a carbon-containing material, a silicon-containing material, and a metal-containing material. In addition, the deposition gas contains unsaturated halon. The unsaturated halon is an unsaturated compound which has a fluorine atom, a bromine atom, and a carbon atom in a molecule and has 2 or 3 carbon atoms. Further, a power density of the bias power applied to the electrode is more than 0 W/cm² and 0.5 W/cm² or less.

## Description

### Technical Field

The present invention relates to a method for forming a deposition film.

### Background Art

In a manufacturing process of a semiconductor element, a gas may be plasma-processed by using an etching device to generate plasma, and etching and deposition may be performed on a semiconductor substrate. An active species (radical) of the plasma that contributes to the etching and deposition reactions has a property of being attracted in a direction of an electric field formed between facing electrodes by a potential difference generated between the facing electrodes to which bias power is applied. This property is referred to as anisotropy.

In a case where the deposition is performed using the etching device, the deposition is deposited on a head top surface and a side wall surface of the pattern formed on the semiconductor substrate and a part of the surface of the semiconductor substrate where the pattern is not formed, and a deposition film covering the surface of the pattern and the surface of the semiconductor substrate is formed. For example, PTLS 1 to 3 disclose a method for forming a deposition film on a semiconductor substrate on which a pattern is formed.

### Citation List

### Patent Literatures

PTL 1: JP 2009-290079 A
PTL 2: JP 2010-153702 A
PTL 3: JP 2012-231162 A

### Summary of Invention

### Technical Problem

However, since it is difficult to sufficiently deposit the deposition on the side wall surface of the pattern parallel to the direction of the above-described electric field due to the above-described anisotropy, the deposition film covering the side wall surface of the pattern tends to have a smaller film thickness than the deposition film covering the head top surface of the pattern perpendicular to the direction of the above-described electric field and the surface of the semiconductor substrate. Therefore, in the technologies disclosed in PTLS 1 to 3, it is difficult to make the film thickness of the deposition film uniform.

In general, it is preferable that the film thickness of the deposition film is uniform. In a case where the deposition film is formed by a method capable of forming the deposition film having a uniform film thickness, it is possible to suppress variation in the film thickness of the deposition film in addition to improving the controllability of the film thickness of the deposition film.

An object of the present invention is to provide a method for forming a deposition film, with which a deposition film having improved uniformity of film thickness can be formed.

### Solution to Problem

To achieve the above-mentioned object, one aspect of the present invention is as the following [1] to [10].
[1] A method for forming a deposition film on a substrate on which a pattern is formed, the method including a deposition step of placing the substrate on an electrode and applying or not applying bias power to the electrode to form a deposition film on the substrate using plasma obtained by plasma-processing a deposition gas,
   in which a material constituting the pattern is at least one of a carbon-containing material, a silicon-containing material, and a metal-containing material,
   the deposition gas contains unsaturated halon which is an unsaturated compound having a fluorine atom, a bromine atom, and a carbon atom in a molecule and having 2 or 3 carbon atoms, and
   in a case where the bias power is applied, a power density of the bias power applied to the electrode is more than 0 W/cm² and 0.5 W/cm² or less.
[2] The method for forming a deposition film according to [1], in which the number of carbon atoms in the unsaturated halon is 2.
[3] The method for forming a deposition film according to [1] or [2], in which the unsaturated halon is an unsaturated compound represented by a chemical formula C₂HₓBrF₍₃₋ₓ₎, and x in the chemical formula is 0, 1, or 2.
[4] The method for forming a deposition film according to any one of [1] to [3], in which the deposition gas further contains an inert gas.
[5] The method for forming a deposition film according to [4], in which the inert gas is at least one of nitrogen gas, helium, neon, argon, krypton, and xenon.
[6] The method for forming a deposition film according to any one of [1] to [5], in which the deposition gas further contains at least one selected from fluorocarbon, hydrofluorocarbon, and hydrogen gas.
[7] The method for forming a deposition film according to [6], in which the fluorocarbon is at least one of carbon tetrafluoride, hexafluoro-1,3-butadiene, octafluorocyclobutane, and octafluorocyclopentene.
[8] The method for forming a deposition film according to [6], in which the hydrofluorocarbon is at least one of trifluoromethane, difluoromethane, and fluoromethane.
[9] The method for forming a deposition film according to any one of [1] to [8], in which the deposition film has a head top portion which is a part formed on the head top surface of the pattern, a side wall portion which is a part formed on a side wall surface of the pattern, and a bottom portion which is a part formed on a part of the surface of the substrate on which the pattern is not formed, and both a ratio of a film thickness of the head top portion to a film thickness of the side wall portion and a ratio of a film thickness of the bottom portion to the film thickness of the side wall portion are 0.7 or more and 1.6 or less.
[10] The method for forming a deposition film according to any one of [1] to [9], in which the deposition film has a side wall portion which is a part formed on a side wall surface of the pattern, and at least a part of the side wall portion is formed to fill a gap between the side wall surfaces of the pattern adjacent to and facing each other.

### Advantageous Effects of Invention

According to the present invention, it is possible to form a deposition film in which uniformity of the film thickness is improved.

### Brief Description of Drawings

FIG. 1 is a schematic diagram of an example of a plasma etching device for illustrating one embodiment of a method for forming a deposition film according to the present invention;
FIG. 2 is a schematic cross-sectional view illustrating an example of a substrate on which a deposition film is formed;
FIG. 3 is a schematic cross-sectional view illustrating an example of a substrate on which a deposition film is formed such that a side wall portion fills a gap between side wall surfaces of patterns adjacent to and facing each other;
FIG. 4 is a schematic cross-sectional view illustrating an example in which a recess is present on an upper surface of an embedded portion of a deposition film;
FIG. 5 is a schematic cross-sectional view illustrating a state of the substrate of FIG. 4 after being etched;
FIG. 6 is a schematic cross-sectional view illustrating a state after the substrate of FIG. 4 is etched by double patterning using an original pattern and the embedded portion as an etching mask;
FIG. 7 is a schematic cross-sectional view illustrating a depth of a recess formed on an upper surface of the embedded portion;
FIG. 8 is a schematic cross-sectional view illustrating an example of a substrate on which deep etching is performed;
FIG. 9 is a schematic cross-sectional view of the substrate on which a first etching step is performed;
FIG. 10 is a schematic cross-sectional view of the substrate on which a first deposition step is performed;
FIG. 11 is a schematic cross-sectional view of the substrate on which a second etching step is performed;
FIG. 12 is a schematic cross-sectional view of the substrate on which a second deposition step is performed;
FIG. 13 is a schematic cross-sectional view of a substrate for illustrating a bowing portion and a bowing amount of a recessed portion formed by deep etching;
FIG. 14 is a schematic cross-sectional view of a substrate illustrating a state in which a gap is generated in a wiring material loaded in an inside of a recessed portion; and
FIG. 15 is a schematic cross-sectional view of a substrate illustrating a state in which a wiring material is polished by a polishing step.

### Description of Embodiments

Embodiments of the present invention will now be described. The embodiments are merely examples of the present invention, and the present invention is not limited to the embodiments. Various modifications or improvements can be made in the embodiments, and such modifications and improvements can be encompassed by the present invention.

A method for forming a deposition film according to the present embodiment is a method for forming a deposition film on a substrate on which a pattern is formed, and includes a deposition step of placing the substrate on an electrode and applying or not applying bias power to the electrode to form a deposition film on the substrate using plasma obtained by plasma-processing a deposition gas. The material constituting the pattern is at least one of a carbon-containing material, a silicon-containing material, and a metal-containing material. In addition, the deposition gas contains unsaturated halon. The unsaturated halon is an unsaturated compound which has a fluorine atom, a bromine atom, and a carbon atom in a molecule and has 2 or 3 carbon atoms. Further, in a case where the bias power is applied, a power density of the bias power applied to the electrode is more than 0 W/cm² and 0.5 W/cm² or less.

The unsaturated halon refers to a halogenated unsaturated hydrocarbon in which some or all of hydrogen atoms of an unsaturated hydrocarbon are substituted with halogen atoms, in which some or all of the halogen atoms substituting the hydrogen atoms are bromine atoms.

In a case where the deposition film is formed by the above-described method, it is possible to form the deposition film in which film thickness uniformity is improved on the substrate on which the pattern is formed. That is, the deposition film includes a head top portion which is a part formed on a head top surface (a surface substantially parallel to a surface of the substrate) of the pattern, a side wall portion which is a part formed on a side wall surface (a surface substantially perpendicular to the surface of the substrate) of the pattern, and a bottom portion which is a part formed on a part of the surface of the substrate on which the pattern is not formed, but in the method for forming a deposition film according to the present embodiment, the deposition film having a uniform thickness can be formed on the head top portion, the side wall portion, and the bottom portion.

For example, a deposition film in which a ratio of a film thickness of the head top portion to a film thickness of the side wall portion is 0.3 or more and 3.5 or less, and a ratio of a film thickness of the bottom portion to the film thickness of the side wall portion is 0.3 or more and 2.8 or less can be formed. The closer the above-described ratio of film thicknesses is to 1, the more uniform the film thickness of the deposition film is (the higher the uniformity of the film thickness of the deposition film).

The ratio of the film thickness of the head top portion to the film thickness of the side wall portion is preferably 0.3 or more and 3.5 or less, more preferably 0.6 or more and 3.2 or less, still more preferably 1.0 or more and 3.0 or less, and particularly preferably 0.7 or more and 1.6 or less.

In addition, the ratio of the film thickness of the bottom portion to the film thickness of the side wall portion is preferably 0.3 or more and 2.8 or less, more preferably 0.6 or more and 2.7 or less, still more preferably 0.7 or more and 2.5 or less, even more preferably 0.7 or more and 1.6 or less, and particularly preferably 0.8 or more and 1.6 or less.

The deposition film may be a film in which at least a part of the side wall portion is formed to fill a gap between the side wall surfaces of the patterns adjacent to and facing each other. That is, the side wall portion of the deposition film may be formed to fill the gap between the side wall surfaces of the patterns adjacent to and facing each other.

The method for forming a deposition film according to the present embodiment can be used for manufacturing a semiconductor element. The deposition film formed in the manufacturing process of the semiconductor element is removed in the end, but has a role as a mask for performing desired etching. In a case where the film thickness of the deposition film is uniform, variation in the effect of the mask can be reduced, so that the accuracy of the etching process is improved.

In addition, in the related art, the deposition film has been often formed by a chemical vapor deposition method (CVD), but according to the method for forming a deposition film according to the present embodiment, the deposition film can be formed by using an etching device, so that it is possible to reduce the manufacturing step of the semiconductor element and improve the productivity. Further, in the method for forming a deposition film according to the present embodiment, the deposition film can be formed without etching the pattern even in a case of using the etching device. Therefore, the pattern shape formed on the substrate is less likely to collapse.

The main component constituting the deposition film in the present invention is a fluorocarbon or a polymer of fluorocarbon. The fluorocarbon and the polymer of fluorocarbon are generated by a deposition radical obtained by plasma-processing the unsaturated halon in the deposition gas.

Hereinafter, the method for forming a deposition film according to the present embodiment will be described in more detail with reference to the drawings.

### <Substrate>

A type of the substrate on which the deposition film is formed by the method for forming a deposition film according to the present embodiment is not particularly limited, and examples of the substrate include a semiconductor substrate such as a silicon substrate.

### <Pattern>

The pattern is formed using a mask manufactured by using a circuit forming technology such as photolithography or nanoimprint or a plasma etching. The material constituting the pattern is at least one of a carbon-containing material, a silicon-containing material, or a metal-containing material. The material constituting the pattern may be used alone or in combination of two or more kinds.

The carbon-containing material means a compound having a carbon atom, and examples of the carbon-containing material include amorphous carbon (C) and a photoresist.

The photoresist means a photosensitive composition in which physical properties such as solubility are changed by light, electron beams, or the like. Examples of the photoresist include a photoresist for a g-ray, a photoresist for an h-ray, a photoresist for an i-ray, a photoresist for KrF, a photoresist for ArF, a photoresist for F2, a photoresist for EUV, and the like. The composition of the photoresist is not particularly limited as long as it is a composition which is generally used in a semiconductor manufacturing step, and examples of the composition include a composition which contains a polymer synthesized from at least one monomer selected from a chain olefin, a cyclic olefin, a (meth)acryloyl group-containing compound, an epoxy group-containing compound, siloxane, and a polyfunctional alcohol (for example, glycol). The term "(meth)acryloyl group" means at least one group of an acryloyl group or a methacryloyl group.

The silicon-containing material means a compound having a silicon atom or silicon alone, and examples of the compound having a silicon atom include a silicon compound such as silicon oxide and silicon nitride.

The silicon oxide refers to a compound having silicon and oxygen at any ratio, and examples of the silicon oxide include silicon dioxide (SiO₂). A purity of silicon oxide is not particularly limited, however, the purity is preferably 30% by mass or more, more preferably 60% by mass or more, and even more preferably 90% by mass or more.

Silicon nitride refers to a compound having silicon and nitrogen at any ratio, and an example of the silicon nitride include Si₃N₄. A purity of silicon nitride is not particularly limited, however, the purity is preferably 30% by mass or more, more preferably 60% by mass or more, and even more preferably 90% by mass or more.

The metal-containing material means a compound having a metal atom or a metal ion, a metal simple substance, or an alloy, and examples of the compound having a metal atom or a metal ion include a metal oxide. Examples of the metal include hafnium, tungsten, aluminum, zirconium, cobalt, tin, ruthenium, and nickel.

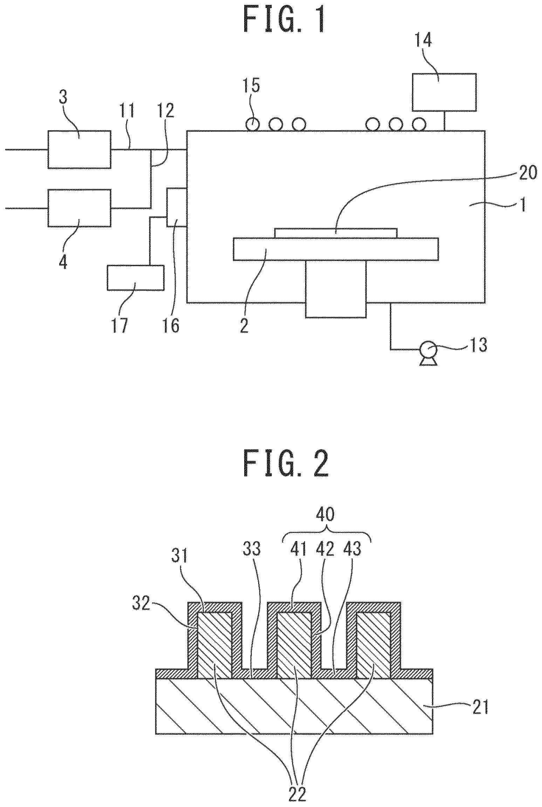

As illustrated in the example of FIG. 2, a cross section of a pattern 22 formed on a substrate 21 is usually substantially rectangular, and the pattern 22 has a head top surface 31 that is substantially parallel to the surface of the substrate 21 and a side wall surface 32 that is substantially perpendicular to the surface of the substrate 21, so that a deposition film 40 is formed on the head top surface 31 and the side wall surface 32. In addition, since the pattern 22 is not formed on a part of the surface of the substrate 21, the deposition film 40 is also formed on this part.

In the present embodiment, in the deposition film 40 formed on the substrate 21, a part formed on the head top surface 31 of the pattern 22 is defined as a head top portion 41, a part formed on the side wall surface 32 of the pattern 22 is defined as a side wall portion 42, and a part formed on a part 33 of the surface of the substrate 21 on which the pattern 22 is not formed is defined as a bottom portion 43.

### <Deposition Gas>

In the method for forming the deposition film according to the present embodiment, a gas containing unsaturated halon is used as a deposition gas. The unsaturated halon is an unsaturated compound which has a fluorine atom, a bromine atom, and a carbon atom in a molecule and has 2 or 3 carbon atoms.

In the process of forming the deposition film, the deposition gas is plasma-processed to generate plasma, and the deposition film is formed by an active species (deposition radical) of the plasma which contributes to the deposition reaction, but since the unsaturated halon has a bromine atom, a carbon bromide compound is generated from the deposition radical.

In a case where a fluorocarbon gas is used as the deposition gas, a fluorocarbon compound is generated from the deposition radical, but in comparison between the carbon bromide compound and the fluorocarbon compound, the carbon bromide compound has a lower bowing point and is easily deposited. Therefore, an amount of the deposition on the side wall surface of the pattern is increased as compared with a case in which the fluorocarbon gas is used as the deposition gas.

The type of the unsaturated halon is not particularly limited as long as it is an unsaturated compound having a fluorine atom, a bromine atom, and a carbon atom in the molecule and having 2 or 3 carbon atoms, and examples of the unsaturated halon include unsaturated halons represented by chemical formula C₂HₓBrF₍₃₋ₓ₎ (wherein x in the chemical formula is 0, 1, or 2) and unsaturated halons represented by chemical formula C₃H_{y}BrF_{(5-y)} (wherein y in the chemical formula is an integer of 0 or more and 4 or less).

Examples of the unsaturated halon represented by the chemical formula C₂HₓBrF₍₃₋ₓ₎ (wherein x in the chemical formula is 0, 1, or 2) include bromotrifluoroethylene (C₂BrF₃), (E)-1-bromo-2-fluoroethylene (C₂H₂BrF), and 1-bromo-1-fluoroethylene (C₂H₂BrF).

Examples of the unsaturated halon represented by the chemical formula C₃H_{y}BrF_{(5-y)} (wherein y in the chemical formula is an integer of 0 or more and 4 or less) include 2-bromopentafluoropropene (C₃BrF₅), bromofluorocyclopropene (C₃H₂BrF), 3-bromo-2-fluoropropene (C₃H₄BrF), 3-bromo-3,3-difluoropropene (C₃H₃BrF₂), 2-bromo-3,3,3-trifluoropropene (C₃H₂BrF₃), and 1-bromo-2,3,3,3-tetrafluoropropene (C₃HBrF₄).

Among these unsaturated halons, an unsaturated halon having 2 carbon atoms is more preferable, and an unsaturated halon represented by a chemical formula C₂HₓBrF₍₃₋ₓ₎ (wherein x in the chemical formula is 0, 1, or 2) is still more preferable.

The unsaturated halon may be used alone or in combination of two or more kinds.

The deposition gas may be a gas formed of only the unsaturated halon, or may be a mixed gas containing the unsaturated halon and an inert gas.

The type of the inert gas is not particularly limited, and examples of the inert gas include nitrogen gas (N₂), helium (He), neon (Ne), argon (Ar), krypton (Kr), and xenon (Xe). These inert gases may be used alone or in combination of two or more kinds.

In addition, the deposition gas may be a mixed gas further containing at least one (hereinafter, also referred to as "additive gas") selected from fluorocarbon, hydrofluorocarbon, and hydrogen gas (H₂). That is, the deposition gas may be a mixed gas containing the unsaturated halon and the additive gas, or may be a mixed gas containing the unsaturated halon, the inert gas, and the additive gas. In a case where the deposition gas contains the additive gas, the shape of the deposition film can be further improved. The additive gas may be used alone or in combination of two or more kinds. The addition amount of the additive gas is preferably 0% by volume or more and 200% by volume or less, and more preferably 50% by volume or more and 1000 by volume or less, with respect to the unsaturated halon.

Examples of the fluorocarbon include carbon tetrafluoride (CF₄), hexafluoro-1,3-butadiene (C₄F₆), octafluorocyclobutane (C₄F₈), and octafluorocyclopentene (C₅F₈).

Examples of the hydrofluorocarbon include trifluoromethane (CHF₃), difluoromethane (CH₂F₂), and fluoromethane (CH₃F).

The concentration of the unsaturated halon in the deposition gas is not particularly limited, and can be set to more than 0% by volume and 100% by volume or less. However, in order to make it difficult to etch the pattern and to generate more of the deposition radical, it is preferable that the concentration of the unsaturated halon in the deposition gas is 3% by volume or more and 70% by volume or less. In addition, in order to easily adjust the film thickness of the deposition film, it is more preferable that the concentration of the unsaturated halon in the deposition gas is 5% by volume or more and 15% by volume or less.

### <Deposition Step>

The deposition step in the method for forming a deposition film according to the present embodiment is carried out by generating plasma by plasma-processing the deposition gas using an etching device or the like. The type of a plasma source that plasma-processes the deposition gas is not particularly limited, and a commercially available plasma generation device may be used. Examples of the plasma include high-frequency discharge plasmas such as inductively coupled plasma (ICP) and capacitively coupled plasma (CCP).

The plasma etching device illustrated in FIG. 1, which will be described in detail later, is a plasma etching device in which an ICP is used as a plasma source.

In addition, in the method for forming a deposition film according to the present embodiment, the plasma may be generated in a plasma generation chamber outside the chamber, by separating the plasma generation chamber and the substrate installation chamber (that is, a remote plasma may be used).

In a case where the deposition step is performed, for example, the substrate on which the pattern is formed is placed on a first electrode (for example, lower electrode) among the at least one electrode installed in the chamber of the plasma etching device, and the deposition gas is introduced into the chamber. In addition, in a case where the deposition gas is plasma-processed to generate a plasma and a bias power equal to or less than a specific power density (including a power density of 0 W/cm²) is applied to the first electrode, the deposition film is formed on the substrate. In a case where the plasma generation device is an ICP or a CCP, the first electrode is a lower electrode of the ICP or the CCP. In addition, in a case where the plasma generation device is a CCP, a second electrode facing the first electrode is provided, and the second electrode is an upper electrode of the CCP.

In the method for forming a deposition film according to the present embodiment, the amount of the deposition gas used, for example, a total flow rate of the deposition gas into a chamber in which the deposition step is performed in the plasma etching device may be adjusted according to an internal volume, an exhaust capacity, a process pressure, and the like of the chamber.

### [Conditions of Deposition Step]

A pressure condition in the deposition step in the method for forming a deposition film according to the present embodiment is not particularly limited, but from the viewpoint of forming a deposition film having a uniform film thickness on the surface of the substrate, the pressure is preferably 0.2 Pa or more and 133.3 Pa or less, more preferably 1 Pa or more and 13.3 Pa or less, still more preferably 1 Pa or more and 10 Pa or less, and particularly preferably 1 Pa or more and 5 Pa or less.

In a case where the pressure is high, the film thickness at the bottom portion of the deposition film is likely to be insufficient, but within the above range, the bottom portion having a sufficient film thickness is easily obtained, and the side wall portion having the film thickness equal to the film thickness of the head top portion and the bottom portion is easily obtained.

In the plasma etching device, for example, by applying a high-frequency source power to a radio frequency (RF) coil to form an electric field and a magnetic field, the deposition gas can be plasma-processed to generate plasma. The magnitude of the source power is not particularly limited, but is preferably more than 0 W and 3000 W or less, more preferably 100 W or more and 1500 W or less, and still more preferably 200 W or more and 1000 W or less. In a case in which the magnitude of the source power is within the above numerical range, the deposition film having the uniform film thickness can be formed at a sufficient rate while suppressing the etching of the pattern.

In a case where there is the second electrode as in a case in which the plasma generation device is a CCP, the power density of the power applied to the second electrode is preferably more than 0 W/cm² and 10 W/cm² or less, more preferably 0.3 W/cm² or more and 5 W/cm² or less, and still more preferably 0.6 W/cm² or more and 3 W/cm² or less. The power density of the power applied to the second electrode is the power per unit area applied to the electrode surface of the second electrode.

A temperature condition of the deposition step in the method for forming a deposition film according to the present embodiment is not particularly limited, but the temperature of the substrate during the formation of the deposition film is preferably -20°C or higher and 250°C or lower, more preferably -20°C or higher and 100°C or lower, and still more preferably 0°C or higher and 70°C or lower. In a case where the temperature of the substrate during the formation of the deposition film is within the above-described numerical range, the deposition film is less likely to be peeled off, and the deposition film is less likely to be etched.

In a case of forming the deposition film, it is necessary to set the power density of the bias power applied to the electrode (first electrode) to 0 W/cm² or more than 0 W/cm² and 0.5 W/cm² or less. In order to suppress the etching during the formation of the deposition film, the power density of the bias power applied to the electrode (first electrode) is preferably more than 0 W/cm² and 0.3 W/cm² or less, and more preferably more than 0 W/cm² and 0.2 W/cm² or less. The power density of the bias power applied to the electrode (first electrode) is the power per unit area applied to the electrode surface of the electrode (first electrode).

By appropriately setting the conditions of the deposition step, that is, the source power, the bias power, the temperature of the substrate, the pressure, the concentration of unsaturated halon in the deposition gas, and the like, and performing the deposition step to form the deposition film, it is possible to further enhance the uniformity of the film thickness of the deposition film.

### [Etching Device]

Hereinafter, an example of a plasma etching device capable of carrying out the method for forming a deposition film according to the present embodiment will be described with reference to FIG. 1. In addition, an example of a method for forming a deposition film on a surface of a substrate on which a pattern is formed will be described using the plasma etching device illustrated in FIG. 1. The plasma etching device of FIG. 1 is a plasma etching device in which an ICP is used as a plasma source. First, the plasma etching device of FIG. 1 will be described.

The plasma etching device of FIG. 1 includes a chamber 1 in which forming of a deposition film is performed inside, a lower electrode 2 (corresponding to a "first electrode") of a facing electrode that supports a substrate 20 on which the deposition film is to be formed inside the chamber 1, a bias power supply (not illustrated) that applies bias power to the facing electrode, an RF coil 15 that forms an electric field and a magnetic field for plasma-processing a deposition gas inside the chamber 1, a source power supply (not illustrated) that applies high-frequency source power to the RF coil 15, a vacuum pump 13 that reduces the pressure inside the chamber 1, a pressure gauge 14 that measures the pressure inside the chamber 1, a sensor 16 that takes in plasma emission generated with the generation of plasma, and a spectroscope 17 that spectrally separates the plasma emission (for example, light having a wavelength in a range from an ultraviolet region to a visible region) taken in by the sensor 16 to monitor a temporal change in the plasma emission.

An example of the substrate 20 is illustrated in FIG. 2. FIG. 2 is a schematic cross-sectional view of a silicon substrate 21 on which the pattern 22 is formed on a surface. The pattern 22 is composed of at least one (for example, a photoresist, silicon oxide, silicon nitride, a metal oxide, and the like) of a carbon-containing material, a silicon-containing material, or a metal-containing material.

As the sensor 16, for example, a charge-coupled device (CCD) image sensor can be used. However, instead of providing the sensor 16 and the spectroscope 17, a peep window may be provided in the chamber 1, and the inside of the chamber 1 may be visually observed from the peep window to confirm the temporal change of the plasma emission.

In addition, the chamber 1 includes a deposition gas supply unit that supplies a deposition gas to the inside of the chamber 1. The deposition gas supply unit includes an unsaturated halon gas supply unit 3 that supplies an unsaturated halon gas, an inert gas supply unit 4 that supplies an inert gas, a deposition gas supply pipe 11 that connects the unsaturated halon gas supply unit 3 to the chamber 1, and an inert gas supply pipe 12 that connects the inert gas supply unit 4 to an intermediate portion of the deposition gas supply pipe 11.

In addition, in a case where the unsaturated halon gas is supplied to the chamber 1 as the deposition gas, the unsaturated halon gas is sent from the unsaturated halon gas supply unit 3 to the deposition gas supply pipe 11, so that the unsaturated halon gas is supplied to the chamber 1 via the deposition gas supply pipe 11.

The pressure in the chamber 1 before the deposition gas is supplied is not particularly limited as long as it is equal to or less than the supply pressure of the deposition gas or is lower than the supply pressure of the deposition gas, but is, for example, preferably 10⁻⁵ Pa or more and less than 100 kPa and more preferably 1 Pa or more and 80 kPa or less.

In addition, in a case where the mixed gas of the unsaturated halon gas and the inert gas is supplied as the deposition gas, the unsaturated halon gas is sent from the unsaturated halon gas supply unit 3 to the deposition gas supply pipe 11, and the inert gas is sent from the inert gas supply unit 4 to the deposition gas supply pipe 11 via the inert gas supply pipe 12. As a result, the unsaturated halon gas and the inert gas are mixed in the intermediate portion of the deposition gas supply pipe 11 to form a mixed gas, and this mixed gas is supplied to the chamber 1 via the deposition gas supply pipe 11.

In a case where the mixed gas of the unsaturated halon gas, the inert gas, and the additive gas is supplied as the deposition gas, the same operation as in a case where the mixed gas of the unsaturated halon gas and the inert gas is supplied as the deposition gas need only be performed, in a case where the configuration of the deposition gas supply unit is a configuration in which the deposition gas supply unit includes an additive gas supply unit and an additive gas supply pipe, together with the unsaturated halon gas supply unit 3, the inert gas supply unit 4, the deposition gas supply pipe 11, and the inert gas supply pipe 12.

In a case where the deposition film is formed using such a plasma etching device, the substrate 20 is placed on the lower electrode 2 disposed inside the chamber 1, the pressure inside the chamber 1 is reduced to, for example, 1 Pa or more and 10 Pa or less by the vacuum pump 13, and then the deposition gas is supplied into the chamber 1 by the deposition gas supply unit. The lower electrode 2 is one of two electrodes constituting the facing electrode.

In addition, in a case where a high frequency (for example, 13.56 MHz) source power is applied to the RF coil 15, an electric field and a magnetic field are formed inside the chamber 1, so that electrons are accelerated, and the accelerated electrons collide with unsaturated halon molecules in the deposition gas to generate new ions and electrons, as a result, discharge occurs and plasma is formed. The generation of the plasma can be confirmed by using the sensor 16 and the spectroscope 17.

In a case where the plasma is generated, a deposition film is formed on the surface of the substrate 20. This will be explained in detail with reference to FIG. 2. The active species (deposition radical) of the plasma is attracted in a direction of the electric field formed between the facing electrodes by a potential difference between the facing electrodes to which a bias power equal to or less than a specific power density (including a power density of 0 W/cm²) is applied (that is, the active species has anisotropy). Therefore, in a case where a deposition film is formed using the etching device, it is not easy to form a deposition film in which deposition is less likely to be deposited on the side wall surface of the pattern and the uniformity of the film thickness is improved.

However, in the method for forming a deposition film according to the present embodiment, since the power density of the bias power applied to the lower electrode 2 (first electrode) is 0 W/cm² or more than 0 W/cm² and 0.5 W/cm² or less, anisotropy is weakened, and the deposition is likely to be deposited on the side wall surface of the pattern. Therefore, the deposition film 40 is uniformly formed on the head top surface 31 and the side wall surface 32 of the pattern 22 and the part 33 of the surface of the substrate 21 on which the pattern 22 is not formed.

That is, in the deposition film 40 formed on the substrate 21, the head top portion 41 which is a part formed on the head top surface 31, the side wall portion 42 which is a part formed on the side wall surface 32, and the bottom portion 43 which is a part formed on the part 33 of the surface of the substrate 21, on which the pattern 22 is not formed, have a uniform film thickness as illustrated in FIG. 2.

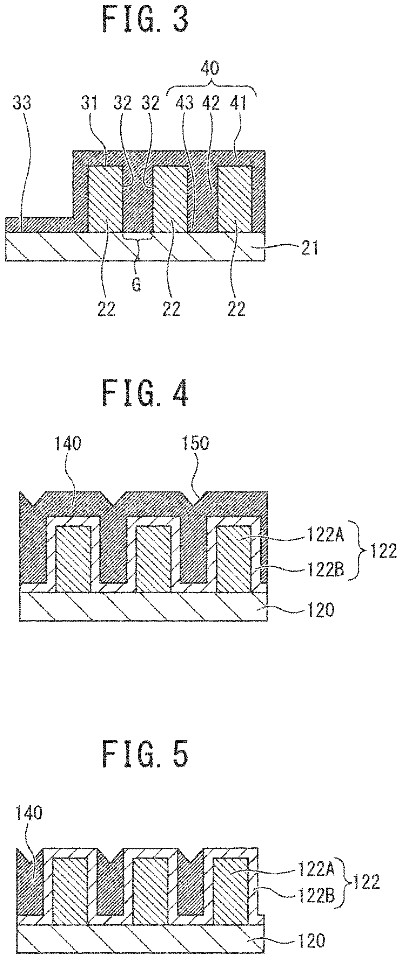

As described above, the deposition film 40 may be a film that is formed to fill a gap G formed between the side wall surfaces 32 and 32 of the patterns 22 and 22 adjacent to and facing each other, at least a part of the side wall portion 42 (see FIG. 3). As illustrated in FIG. 3, the gap G is filled with the deposition film 40 (side wall portion 42). In a part of the side wall portion 42 that is formed to fill the gap G, the side wall portion 42 and the bottom portion 43 may be integrated.

Examples of a technology (hereinafter, a process of forming the deposition film such that the side wall portions fill the gap is also referred to as "embedding", and the side wall portion formed to fill the gap is also referred to as an "embedded portion") of forming the deposition film such that the side wall portions fill the gap between the side wall surfaces of the patterns adjacent to and facing each other include a double patterning which is a semiconductor fine patterning technology.

In the double patterning, the etching processing is performed after the embedding to remove a deposition film 140 deposited on an original pattern 122 (including a first pattern 122A and a second pattern 122B), but in a case in which a recess 150 is present on the upper surface (a surface substantially parallel to the surface of the substrate) of the embedded portion (see FIG. 4), the upper surface of the embedded portion is lower than the upper surface of the second pattern 122B after the etching processing (see FIG. 5).

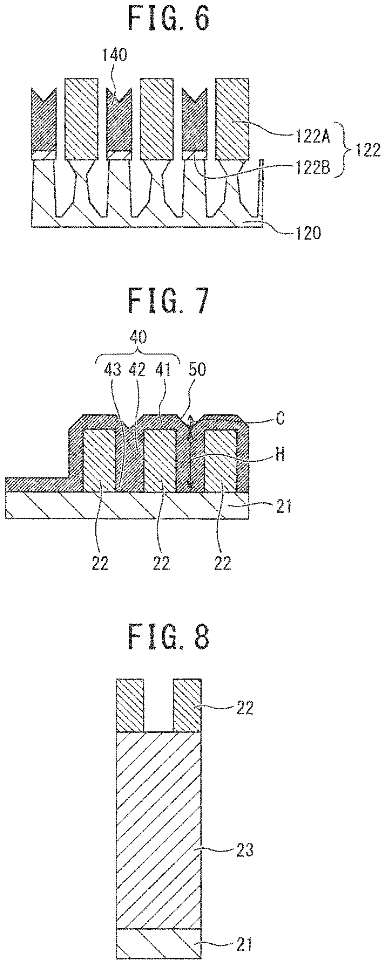

In the double patterning, the original pattern 122A and the embedded portion forming a new pattern are used as etching masks, and the original pattern 122B and a lower layer film 120 on the substrate are further etched (see FIG. 6). Therefore, in a case in which the upper surface of the embedded portion is lower than the upper surface of the second pattern 122B, the thickness of the etching mask varies. In a case where the thickness of the etching mask varies, it is not preferable because it causes variation in the shape of the lower layer film 120 after etching. For such a reason, the recess is not present on the upper surface of the embedded portion, and the upper surface of the embedded portion (the side wall portion 42) is preferably flat as illustrated in FIG. 3.

The conditions of the deposition step in a case where the deposition film is formed to fill the gap of the side wall portion are the same as the conditions of the deposition step described above, but since there is a tendency that the upper surface of the embedded portion is flattened as the bias power is stronger, the power density of the bias power is preferably more than 0 W/cm² and 0.5 W/cm² or less, more preferably 0.1 W/cm² or more and 0.5 W/cm² or less, and still more preferably 0.3 W/cm² or more and 0.5 W/cm² or less.

In addition, with regard to the pattern forming the gap during the embedding, in a case where a ratio (hereinafter, referred to as "aspect ratio") of a height of the pattern to a size (width) of the gap is large, deposition is less likely to be deposited on a side wall surface of the pattern, and it is difficult to completely fill the gap with the deposition. Therefore, the aspect ratio is preferably more than 0 and 15 or less, more preferably 0.5 or more and 5 or less, and still more preferably 1 or more and 3 or less.

Further, an embedding process time is as follows. The size of the gap in which the embedding is performed is denoted by X (nm), and a deposition rate of the side wall portion is denoted by Y (nm/s). The process time requires at least a time for completely filling the gap with the deposition, and the deposition after the upper surface of the embedded portion is flattened is not necessary. Therefore, the process time is preferably (X/2)/Y seconds or more and 6 × (X/2)/Y seconds or less, more preferably 2 × (X/2)/Y seconds or more and 5 × (X/2)/Y seconds or less, and still more preferably 3 × (X/2)/Y seconds or more and 4 × (X/2)/Y seconds or less.

That is, the embedding process time is preferably 1 time or more and 6 times or less, more preferably 2 times or more and 5 times or less, and still more preferably 3 times or more and 4 times or less the time required for the side wall portion to exactly fill the gap.

Furthermore, the depth (recess amount) of the recess 50 formed on the upper surface of the embedded portion is as follows. A ratio of a recess amount C to a height H of the pattern 22 is defined as a recess ratio (see FIG. 7). The recess ratio is preferably 0 or more and 0.1 or less, more preferably 0 or more and 0.05 or less, and still more preferably 0 or more and 0.01 or less.

The deposition film 40 is derived from the unsaturated halon which is the deposition gas. For example, in a case where the unsaturated halon is 1-bromo-1-fluoroethylene, 1-bromo-1-fluoroethylene is decomposed by plasma to generate CF₂, and polytetrafluoroethylene is generated from this CF₂. The generated polytetrafluoroethylene is deposited on the substrate 21 to form the deposition film 40.

The supply amount of the deposition gas to the chamber 1 and the concentration of the unsaturated halon gas in the deposition gas (mixed gas) can be adjusted by controlling the flow rate of the unsaturated halon gas and the inert gas by a mass flow controller (not illustrated) installed in the deposition gas supply pipe 11 and the inert gas supply pipe 12, respectively.

In addition, the method for forming a deposition film according to the present embodiment can be used in a case of performing deep etching as described below. An example of the deep etching will be described with reference to FIGS. 8 to 12.

A film 23 consisting of an etching target (for example, silicon oxide) to be etched by the deep etching is formed on the substrate 21 such as the silicon substrate, and the pattern 22 consisting of, for example, a carbon-containing material (for example, a photoresist) is formed on the film 23 to obtain the substrate 21 on which the pattern 22 is formed (see FIG. 8).

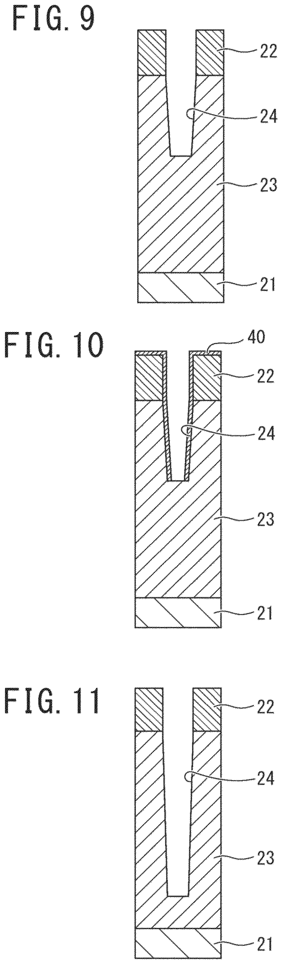

The deep etching is performed on the substrate 21 on which the pattern 22 is formed, but first, a first etching step is performed to transfer the pattern 22 to the film 23 and to form the recessed portion 24 (see FIG. 9). Following the first etching step, a first deposition step is performed on the substrate 21 on which the pattern 22 has been formed to form the deposition film 40 on the head top surface and the side wall surface of the pattern 22 and the side surface of the recessed portion 24 (see FIG. 10). In the first deposition step, a deposition gas containing, for example, unsaturated halon such as bromotrifluoroethylene is used.

Next, following the first deposition step, a second etching step is performed on the substrate 21 on which the pattern 22 has been formed to further increase the depth of the recessed portion 24 (see FIG. 11). At this time, the recessed portion 24 is deeply dug, and the deposition film 40 formed on the head top surface and the side wall surface of the pattern 22 and on the side surface of the recessed portion 24 is removed.

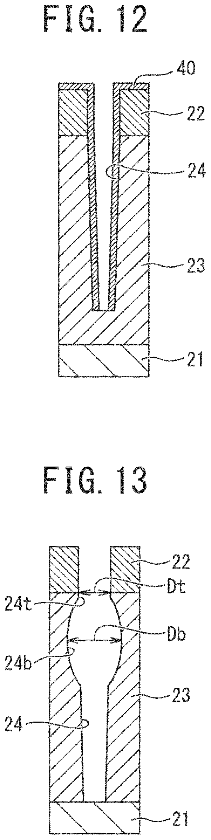

Next, following the second etching step, a second deposition step is performed on the substrate 21 on which the pattern 22 has been formed, and the deposition film 40 is formed on the head top surface and the side wall surface of the pattern 22 and the side surface of the recessed portion 24 in the same manner as in the first deposition step (see FIG. 12).

In this way, the deep etching can be performed by alternately repeating the etching step and the deposition step. In the etching step at that time, the decrease in the thickness of the pattern 22 is suppressed by the deposition film 40 formed on the head top surface of the pattern 22. In addition, the deposition film 40 formed on the side surface of the recessed portion 24 prevents the side surface of the recessed portion 24 from being etched and the size of the recessed portion 24 in a radial direction (that is, a direction orthogonal to a depth direction) from being expanded (that is, bowing). In addition, since the decrease in thickness of the pattern 22 and the bowing of the recessed portion 24 are suppressed, in the deep etching, the recessed portion 24 having a certain shape is likely to be formed.

The amount of bowing generated in the etching step (hereinafter, also referred to as a "bowing amount") is preferably small, and is preferably -30 nm or more and 30 nm or less, more preferably -10 nm or more and 10 nm or less, and still more preferably -5 nm or more and 5 nm or less.

Here, the bowing amount is defined as follows. The bowing amount will be described with reference to FIG. 13. The film 23 consisting of the etching target which the target of the etching by the deep etching is laminated on the substrate 21, and the pattern 22 is formed on the film 23. In addition, the film 23 is formed with the recessed portion 24 to which the pattern 22 is transferred by etching. The recessed portion 24 is a through-hole penetrating the film 23 in a thickness direction. A diameter of a top portion 24t of the recessed portion 24, that is, a diameter of the boundary part between the pattern 22 and the film 23 is denoted by Dt, and a diameter of the bowing portion 24b of the recessed portion 24, that is, a diameter of a part of the side surface of the bowed and recessed portion 24, which is most largely etched in the radial direction (direction orthogonal to the depth direction of the recessed portion 24) of the recessed portion 24 is denoted by Db. In this case, a value obtained by subtracting the diameter Dt of the top portion 24t from the diameter Db of the bowing portion 24b is defined as the bowing amount.

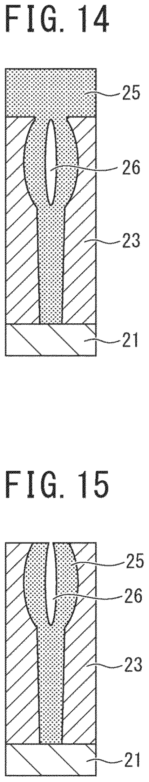

In a case where the etching causes the bowing in the recessed portion 24, the following inconvenience may occur. That is, in a case where the pattern 22 is removed after the etching, and then a wiring material 25 such as metal is loaded into the inside of the recessed portion 24, a gap 26 called a void or a seam may occur in the bowing portion 24b or the like of the recessed portion 24 (see FIG. 14).

After the wiring material 25 such as a metal is loaded into the inside of the recessed portion 24, the substrate 21 is subjected to a polishing step of polishing off the excess wiring material 25 or a washing step, but in a case in which the gap 26 is generated in the wiring material 25 inside the recessed portion 24, in the polishing step or the washing step after the polishing step, an abrasive used in the polishing step or a detergent used in the washing step remains in the gap 26 and tends to become a foreign matter (see FIG. 15). Such a foreign matter is not preferable because it causes a decrease in the yield of the wafer and the occurrence of abnormal characteristics.

### Examples

Hereinafter, the present invention will be described more specifically by describing examples and comparative examples.

### (Example 1)

A deposition film was formed on the surface of the substrate using an inductively coupled plasma (ICP) etching device RIE-200iP manufactured by Samco Inc., which had substantially the same configuration as the plasma etching device of FIG. 1.

The substrate has substantially the same configuration as the substrate in FIG. 2. That is, a line-shaped pattern formed of silicon oxide is formed on the silicon substrate. A cross-sectional shape of the pattern is substantially rectangular, and a thickness (height) of the cross-sectional shape is 300 nm. The substrate was produced as follows.

A silicon oxide film having a film thickness of 300 nm was formed on the silicon substrate, and a resist pattern (not illustrated) which was patterned in a line-and-space of 250 nm in width was formed on the silicon oxide film. The resist pattern was formed by photolithography using a KrF resist. The silicon oxide film was etched by plasma etching using this resist pattern as a mask to form a line-shaped pattern composed of silicon oxide. Thereafter, the remaining resist pattern was removed by an oxygen plasma.

An internal volume of a chamber of the etching device is 46,000 cm³, and the deposition gas is a mixed gas of bromotrifluoroethylene gas and argon. By setting the flow rate of the bromotrifluoroethylene gas to 10 sccm and the flow rate of the argon to 90 sccm with a mass flow controller, the concentration of the bromotrifluoroethylene gas in the deposition gas was adjusted to 20% by volume. Here, sccm is a volume flow rate (cm³) standardized under a condition of 0°C and 1 atm per minute.

The substrate produced as described above was placed on the lower electrode installed inside the chamber. An electrode area of the lower electrode is 324 cm². Then, the inside process pressure of the chamber was set to 3 Pa, the source power was set to 500 W, the bias power was set to 50 W, the temperature of the substrate was set to 20°C, and the flow rate of the bromotrifluoroethylene gas, the flow rate of the argon, the process pressure, the source power, and the bias power were always monitored. While confirming that there was no difference between each set value and each actual value, a deposition film was formed for 10 minutes. The generation of the plasma was confirmed by monitoring the temporal change of the plasma light emission with a sensor or visually. It should be noted that the above-described processing conditions are set in consideration of preventing the pattern from being etched.

After the formation of the deposition film was completed, the substrate was taken out from the chamber of the etching device, and the taken out substrate was cut out using a diamond cutter such that the cut surface was an observation surface to produce a rectangular piece having a size of about 5 mm in length and 3 mm in width. A piece was analyzed at a magnification of 100,000 times using a scanning electron microscope (SEM) manufactured by Hitachi High-Tech Corporation, and a film thickness of the deposition film was measured. The film thickness was measured for the head top portion, the side wall portion, and the bottom portion of the deposition film (see FIG. 2). In addition, the ratio of the film thickness of the head top portion to the film thickness of the side wall portion and the ratio of the film thickness of the bottom portion to the film thickness of the side wall portion were calculated. The results are shown in Table 1.

**[Table 1]**

| | Deposition gas | | | | | Temperature of substrate (°C) | Pressure in chamber (Pa) | Power density of source power (W/cm²) | Power density of bias power (W/cm²) | Deposition time (s) | Film thickness of deposition film | | | Ratio of film thickness ^{*1)} | |
|---|---|---|---|---|---|---|---|---|---|---|---|---|---|---|---|
| | C₂BrF₃ (sccm) | C₂H₂BrF (sccm) | C₄F₆ (sccm) | CF₄ (sccm) | Ar (sccm) | | | | | | Head top portion (nm) | Side wall portion (nm) | Bottom portion (nm) | Head top portion | Bottom portion |
| Ex. 1 | 10 | - | - | - | 90 | 20 | 3 | 1.54 | 0.15 | 600 | 66 | 44 | 56 | 1.5 | 1.3 |
| Ex. 2 | - | 10 | - | - | 40 | 20 | 3 | 0.93 | 0.15 | 120 | 96 | 62 | 82 | 1.5 | 1.3 |
| Ex. 3 | - | 10 | - | - | 40 | 20 | 3 | 0.93 | 0.46 | 120 | 72 | 67 | 51 | 1.1 | 0.8 |
| Ex. 4 | - | 10 | - | 5 | 40 | 20 | 3 | 0.93 | 0.46 | 120 | 86 | 65 | 82 | 1.3 | 1.3 |
| Ex. 5 | - | 50 | - | - | - | 20 | 3 | 0.93 | 0.15 | 120 | 97 | 74 | 68 | 1.3 | 0.9 |
| Ex. 6 | - | 10 | - | - | 40 | 20 | 3 | 1.54 | 0.15 | 120 | 60 | 54 | 45 | 1.1 | 0.8 |
| Ex. 7 | - | 10 | - | - | 40 | 20 | 1 | 0.93 | 0.15 | 120 | 86 | 66 | 59 | 1.3 | 0.9 |
| Ex. 8 | - | 10 | - | - | 40 | 0 | 3 | 0.93 | 0.15 | 120 | 92 | 69 | 75 | 1.3 | 1.1 |
| Ex. 9 | - | 5 | - | - | 20 | 20 | 3 | 0.93 | 0.15 | 120 | 28 | 29 | 22 | 1.0 | 0.8 |
| Ex. 10 | - | 5 | - | - | 20 | 20 | 3 | 0.93 | 0.15 | 800 | 142 | 125 | 113 | 1.1 | 0.9 |
| Ex. 11 | 10 | - | - | - | 40 | 20 | 3 | 0.93 | 0 | 120 | 135 | 45 | 116 | 3.0 | 2.5 |
| Ex. 12 | - | 10 | - | - | 40 | 20 | 3 | 0.93 | 0 | 120 | 102 | 45 | 69 | 2.3 | 1.5 |
| Ex. 13 | - | 5 | - | - | 45 | 20 | 3 | 0.93 | 0 | 120 | 60 | 25 | 37 | 2.4 | 1.5 |
| Ex. 14 | - | 5 | - | - | 20 | 20 | 3 | 0.93 | 0 | 120 | 75 | 25 | 40 | 3.0 | 1.6 |
| Comp. Ex. 1 | - | - | 10 | - | 40 | 20 | 3 | 0.93 | 0 | 120 | 110 | 23 | 70 | 4.7 | 3.0 |
| Comp. Ex. 2 | - | 10 | - | - | 40 | 20 | 3 | 0.93 | 1.85 | 120 | 0 | 60 | 0 | - | - |
| Comp. Ex. 3 | 10 | - | - | - | 90 | 20 | 2 | 154 | 0.62 | 600 | 0 | 71 | 0 | - | - |

| | | | | | | | | | | | | | | | |
|---|---|---|---|---|---|---|---|---|---|---|---|---|---|---|---|
| *1) is ratio of film thickness of head top portion and ratio of film thickness of bottom portion when film thickness of side wall portion is 1 | | | | | | | | | | | | | | | |

### (Examples 2 to 14 and Comparative Examples 1 to 3)

A deposition film was formed in the same manner as in Example 1, except that the type and the flow rate of the deposition gas and various processing conditions were set as shown in Table 1. The film thickness of the deposition film was measured in the same manner as in Example 1, and the ratio of the film thickness was calculated. The results are shown in Table 1. "C₂H₂BrF" described in the column of the deposition gas in Table 1 is 1-bromo-1-fluoroethylene, and "C₄F₆" is hexafluoro-1,3-butadiene.

Comparative Example 1 is an example in which the deposition gas did not contain the unsaturated halon, but since the deposition was unlikely to be deposited in the corner portion between the head top surface and the side wall surface of the pattern, an overhang in which the deposition was deposited in a form of an eaves on the head top surface was generated. In addition, a film thickness of the side wall portion of the deposition film was smaller than the film thicknesses of the head top portion and the bottom portion. This is because, in a case where the deposition film is formed using the etching device, the anisotropy increases, and thus the deposition on the side wall surface of the pattern is deteriorated.

Comparative Example 2 is an example in which the bias power is large with respect to Example 2, but the etching has proceeded, the film thickness at the head top portion is thin, and the deposition film is not deposited on the bottom portion, and the silicon substrate is etched.

In Comparative Example 3, the bias power was also large, but the etching proceeded as in Comparative Example 2.

On the other hand, in Examples 1 to 9, since the deposition was sufficiently deposited in the corner portion between the head top surface and the side wall surface of the pattern, no overhang in which the deposition was deposited on the head top surface in a form of an eaves was generated. In addition, the ratio of the film thickness of the head top portion to the film thickness of the side wall portion and the ratio of the film thickness of the bottom portion to the film thickness of the side wall portion are also close to 1, and it can be seen that a deposition film having a uniform thickness of the head top portion, the side wall portion, and the bottom portion is formed as compared with Comparative Examples 1 to 3.

Example 10 is an example in which the deposition film was formed by increasing the deposition time with respect to Example 9, so that the side wall portion filled the gap formed between the side wall surfaces of the adjacent and facing patterns. The deposition time in Example 10 was 1.5 times the time required for the side wall portion to fill the above-described gap.

From Table 1, it can be seen that, in Example 10, a deposition film having a uniform thickness at the head top portion, the side wall portion, and the bottom portion is formed as in Examples 1 to 9, as compared with Comparative Examples 1 to 3. The thickness of the side wall portion was 50% of the above-described gap. In addition, the thickness of the bottom portion was a thickness of the bottom portion formed in a part where the above-described gap was not buried in the side wall portion.

Furthermore, in Example 10, in a case where the recess amount of the recess formed on the upper surface of the embedded portion was measured, the recess amount was 10 nm. Therefore, since the recess ratio, which is the ratio of the recess amount to the height (300 nm) of the pattern, was 0.03, it was confirmed that the upper surface of the embedded portion was flat.

Meanwhile, in Examples 11 to 14 in which the bias power was not applied (that is, the power density of the bias power was 0 W/cm²), the ratio of the film thickness of the head top portion to the film thickness of the side wall portion and the ratio of the film thickness of the bottom portion to the film thickness of the side wall portion were slightly larger than those in Examples 1 to 10 in which the power density of the bias power was more than 0 W/cm² and 0.5 W/cm² or less.

### (Example 15 and Reference Example 1)

Example 15 is an example of the deep etching described above. The substrate used in Example 15 had a configuration substantially the same as the substrate of FIG. 9. That is, a silicon oxide film having a thickness of 2 um is formed on the silicon substrate, and a pattern consisting of a photoresist is further formed on the silicon oxide film. The pattern has a through-hole (recessed portion) penetrating the pattern in a thickness direction. A diameter of the through-hole is 250 nm.

The deep etching in which the etching step and the deposition step were alternately repeated was performed on the above-described substrate. That is, the first etching step, the first deposition step, the second etching step, the second deposition step, and the third etching step were performed in this order of description.

The etching gas used in the first, second, and third etching steps is a mixed gas of octafluorocyclobutane, an oxygen gas, and argon. In addition, the deposition gas used in the first and second deposition steps is a gas of bromotrifluoroethylene. Hereinafter, etching conditions and deposition conditions of each of the above-described steps are shown. As shown below, the etching conditions of the first, second, and third etching steps are all the same. In addition, as shown below, the deposition conditions of the first and second deposition steps are the same.

### [First, Second, and Third Etching Steps]

Plasma source: capacitively coupled plasma
Pressure: 4 Pa
RF power (27 MHz): 1.85 W/cm² (value per electrode area of 324 cm²)
RF power (2 MHz): 6.17 W/cm² (value per electrode area of 324 cm²)
Flow rate of octafluorocyclobutane: 20 sccm
Flow rate of oxygen gas: 10 sccm
Flow rate of argon: 400 sccm
Temperature of substrate: 20°C
Etching time: 120 seconds

### [First and Second Deposition Steps]

Plasma source: inductively coupled plasma
Pressure: 1 Pa
Source power: 0.93 W/cm² (value per electrode area of 324 cm²)
Bias power: 0.03 W/cm² (value per electrode area of 324 cm²)
Flow rate of bromotrifluoroethylene: 20 sccm
Temperature of substrate: 40°C
Deposition time: 120 seconds

The diameter of the top portion and the diameter of the bowing portion of the recessed portion formed on the substrate of Example 15 by the deep etching (see FIG. 13) were measured using an electron microscope. As a result, the diameter of the top portion of the recessed portion was 222 nm, and the diameter of the bowing portion of the recessed portion was 222 nm. Therefore, the bowing amount was 0 nm.

Reference Example 1 was the same as the substrate used in Example 15, and was obtained by performing only the etching step for 360 seconds without performing the deposition step in the deep etching performed in Example 15. In Reference Example 1 as well, the diameter of the top portion of the recessed portion formed on the substrate by etching and the diameter of the bowing portion were measured using an electron microscope, as in the case of Example 15. As a result, the diameter of the top portion of the recessed portion was 220 nm, and the diameter of the bowing portion of the recessed portion was 255 nm. Therefore, the bowing amount was 35 nm.

In a case where the bowing amounts of Example 15 and Reference Example 1 were compared, the bowing amount of Example 15 was smaller than that of Reference Example 1. As a result, it was confirmed that the bowing amount could be reduced by repeating the etching step and the deposition step as in Example 15.

### Reference Signs List

- 1: chamber
- 2: lower electrode
- 3: unsaturated halon gas supply unit
- 4: inert gas supply unit
- 11: deposition gas supply pipe
- 12: inert gas supply pipe
- 13: vacuum pump
- 14: pressure gauge
- 15: RF coil
- 16: sensor
- 17: spectroscope
- 20: substrate
- 21: substrate
- 22: pattern
- 31: head top surface
- 32: side wall surface
- 33: part of surface of substrate on which pattern is not formed
- 40: deposition film
- 41: head top portion
- 42: side wall portion
- 43: bottom portion

## Claims

1. A method for forming a deposition film on a substrate on which a pattern is formed, the method comprising a deposition step of placing the substrate on an electrode and applying or not applying bias power to the electrode to form a deposition film on the substrate using plasma obtained by plasma-processing a deposition gas,
wherein a material constituting the pattern is at least one of a carbon-containing material, a silicon-containing material, and a metal-containing material,
the deposition gas contains unsaturated halon which is an unsaturated compound having a fluorine atom, a bromine atom, and a carbon atom in a molecule and having 2 or 3 carbon atoms, and
in a case where the bias power is applied, a power density of the bias power applied to the electrode is more than 0 W/cm² and 0.5 W/cm² or less.

2. The method for forming a deposition film according to claim 1, wherein the number of carbon atoms in the unsaturated halon is 2.

3. The method for forming a deposition film according to claim 1 or 2, wherein the unsaturated halon is an unsaturated compound represented by a chemical formula C₂HₓBrF₍₃₋ₓ₎, and x in the chemical formula is 0, 1, or 2.

4. The method for forming a deposition film according to claim 1 or 2, wherein the deposition gas further contains an inert gas.

5. The method for forming a deposition film according to claim 4, wherein the inert gas is at least one of nitrogen gas, helium, neon, argon, krypton, and xenon.

6. The method for forming a deposition film according to claim 1 or 2, wherein the deposition gas further contains at least one selected from fluorocarbon, hydrofluorocarbon, and hydrogen gas.

7. The method for forming a deposition film according to claim 6, wherein the fluorocarbon is at least one of carbon tetrafluoride, hexafluoro-1,3-butadiene, octafluorocyclobutane, and octafluorocyclopentene.

8. The method for forming a deposition film according to claim 6, wherein the hydrofluorocarbon is at least one of trifluoromethane, difluoromethane, and fluoromethane.

9. The method for forming a deposition film according to claim 1 or 2, wherein the deposition film has a head top portion which is a part formed on a head top surface of the pattern, a side wall portion which is a part formed on a side wall surface of the pattern, and a bottom portion which is a part formed on a part of the surface of the substrate on which the pattern is not formed, and both a ratio of a film thickness of the head top portion to a film thickness of the side wall portion and a ratio of a film thickness of the bottom portion to the film thickness of the side wall portion are 0.7 or more and 1.6 or less.

10. The method for forming a deposition film according to claim 1 or 2, wherein the deposition film has a side wall portion which is a part formed on a side wall surface of the pattern, and at least a part of the side wall portion is formed to fill a gap between the side wall surfaces of the pattern adjacent to and facing each other.
